# EUROPEAN PATENT SPECIFICATION

(11) **EP 1 741 765 B1**
(45) Date of publication and mention of the grant of the patent: **07.01.2009**
(21) Application number: 06019655.7
(22) Date of filing: 27.04.2001
(51) Int. Cl.: C09K 11/06, C08F 38/00, C08G 61/02, H01L 51/00

(54) **Organic luminous material and organic light-emitting device**
Organisches lumineszentes Material und lichtemittierende Vorrichtung
Matière organique lumineuse et dispositif organique électroluminescent

(30) Priority: 27.04.2000 JP 2000128364; 22.09.2000 JP 2000288692; 24.04.2001 JP 2001125359
(43) Date of publication of application: 10.01.2007
(62) Divisional of application: 01303861.7
(73) Proprietor: FUJITSU LIMITED, Kawasaki-shi, Kanagawa 211-8588 (JP)
(72) Inventor: Yoshikawa, Kota, Kawasaki-shi Kanagawa 211-8588 (JP); Kijima, Masashi, Tsukuba-shi Ibaraki 305-8573 (JP); Shirakawa, Hideki, Yokohama-shi Kanagawa (JP); Kinoshita, Ikuo, Kanagawa 250-0112 (JP)
(74) Representative: Fenlon, Christine Lesley

(56) References cited:
- DE-A1- 4 339 646
- TAO X T ET AL: "Novel main-chain poly-carbazoles as hole and electron transport materials in polymer light-emitting diodes" APPLIED PHYSICS LETTERS, AIP, AMERICAN INSTITUTE OF PHYSICS, MELVILLE, NY, US, vol. 71, no. 14, 1997, pages 1921-1923, XP002339411 ISSN: 0003-6951
- REMMERS M ET AL: "THE OPTICAL, ELECTRONIC, AND ELECTROLUMINESCENT PROPERTIES OF NOVELPOLY(P-PHENYLENE)-RELATED POLYMERS" MACROMOLECULES, AMERICAN CHEMICAL SOCIETY. EASTON, US, vol. 29, no. 23, 4 November 1996 (1996-11-04), pages 7432-7445, XP000631108 ISSN: 0024-9297
- TASCH S ET AL: "Efficient white light-emitting diodes realized with new processable blends of conjugated polymers" APPLIED PHYSICS LETTERS, AIP, AMERICAN INSTITUTE OF PHYSICS, MELVILLE, NY, US, vol. 71, no. 20, 1997, pages 2883-2885, XP002339412 ISSN: 0003-6951
- YANG M ET AL: "Characterization and fluorescence properties of thiophene-modified pi-conjugated nickel poly-yne polymers" POLYMER, ELSEVIER SCIENCE PUBLISHERS B.V, GB, vol. 40, no. 11, May 1999 (1999-05), pages 3203-3209, XP004157673 ISSN: 0032-3861
- HOLZER W ET AL: "Excitation intensity-dependent fluorescence behaviour of some luminescent polymers" POLYMER, ELSEVIER SCIENCE PUBLISHERS B.V, GB, vol. 39, no. 16, July 1998 (1998-07), pages 3651-3656, XP004120980 ISSN: 0032-3861
- HATTORI T ET AL: "Photoinduced absorption and luminescence in polydiacetylenes" JOURNAL OF PHYSICS C: SOLID STATE PHYSICS, INSTITUTE OF PHYSICS PUBLISHING, BRISTOL, GB, vol. 17, 1984, pages L881-L888, XP002339413 ISSN: 0022-3719

## Description

The present invention relates to an organic luminous material and an organic light-emitting device and, more particularly, to an organic light-emitting device like an organic electroluminescence (EL) device employing such material.

In recent years, the research and development of an organic EL device applied to a flat display panel, a mobile display device, etc. has been vigorously pursued. A display device employing an organic EL device can provide high brightness and full color display by low voltage driving.

In addition, a display device consisting of an organic EL devices has features different from a liquid crystal display (LCD). For example, there can be provided a light weight and low cost product that has no viewing angle dependence because it is a spontaneously emissive display, does not need back lights because of the high contrast, has a quick response speed, has an easy film formation characteristic, and withstands impact since the overall device is constructed from solid state elements.

An organic EL device has a structure made up of lower electrode formed of transparent conductive material, an organic thin film (luminous layer), and an upper electrode formed of magnesium, potassium, etc. formed in sequence on the glass substrate, for example. The thickness of the overall structure can be reduced up to about several mm. Then, light is emitted from the luminous layer by applying a DC voltage between the lower electrode and the upper electrode, and this light is passed through the lower electrode and the glass substrate to output to the outside. The organic EL device is an injection electroluminescence device that increases the number of carriers in operation by injecting the carriers from the electrode to thus emit light by recombination. Sometimes the organic EL device is also called an organic LED.

As the luminous material employed in the organic thin film of the organic EL device, there are used monomer materials and polymer materials. Normally a film of monomer material is formed by the vacuum evaporation method, and normally a film of polymer material is formed by a coating method. Coating methods are practical in device formation because expensive equipment is not needed.

It is known to employ PPV (poly p-phenylenevinylene) as the polymer material. An EL device employing such material is set forth in Patent Application Publication (KOKAI) Hei 10-326675, for example.

The article by X.T. Tao et al: "Novel main - chain poly-carbazoles as hole and electron transport materials in polymer light-emitting diodes", Appl. Phys. Lett 71(14), 6 October, 1997, XP-002339411 discloses the use of substituted main-chain poly-carbazoles as hole and electron-transporting polymers for EL applications. The polymers are soluble in common organic solvents and high quality thin films are obtained by a spin coating method.

A conjugated polymer material such as PPV employed as the luminous layer in the prior art is in a highly crystalline state at normal temperature, unlike a normal polymer material.

Accordingly, if such conjugated polymer material is formed on the substrate, unevenness readily occurs on the surface of the luminous layer made of the polymer.

If a voltage is applied between the lower electrode and the upper electrode under conditions such that unevenness is present on the surface of the luminous layer, the electric field is readily concentrated in the concave portion of the surface of the luminous layer. Thus, there is the possibility that the luminous layer is destroyed by the electric field, and then a short-circuit is caused between the lower electrode and the upper electrode.

Also, since the luminous polymer layer in the prior art, which is readily crystallised, is insoluble in the organic solvent, treatment must be applied, e.g., the polymer must be mixed into the organic solvent while being heated, when the polymer is coated on the substrate, and thus it is not easy to handle the polymer. In addition, even if the conjugated polymer in the prior art is dissolved in the organic solvent, such polymer is still readily crystallized after cooling.

It is an object of the present invention to provide a light-emitting device having a luminous layer formed of polymer material that can be highly planarized and has a solubility in organic solvents higher than that of polymer film material in the prior art.

According to a first aspect of the present invention there is provided an organic luminous material having the general formula 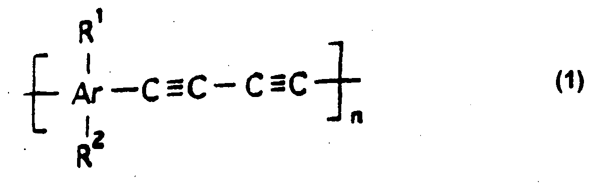 where Ar denotes an arylene group, R¹ and R² denote substituents which can be the same or different and n denotes the degree of polymerisation; wherein an aromatic ring comprised by the arylene group is any one of thiophene, anthracene, pyridine, phenol, aniline and derivatives thereof, and the said substituents are selected from hydrogen, alkyl, alkoxy, carboxyl, cyano, phenyl, biphenyl and cyclohexylphenyl.

According to a second aspect of the present invention there is provided an organic light-emitting device comprising: a lower electrode; a luminous layer formed on the lower electrode, which is the organic luminous material embodying the first aspect of the present invention; and an upper electrode formed on the luminous layer.

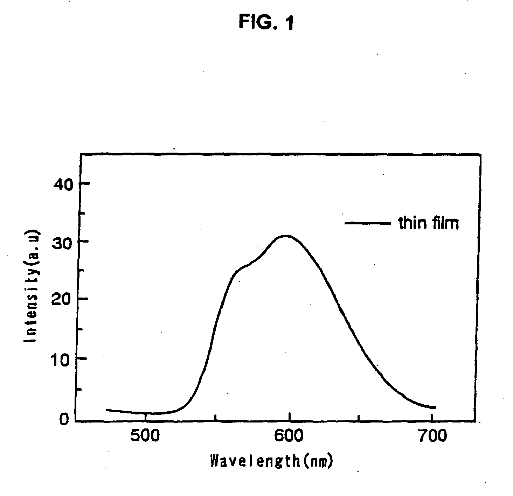

For a better understanding of the invention, and to show how the same may be carried into effect, reference will now be made, by way of example, to the accompanying drawing, in which:-
FIG.1 is a graph showing the fluorescent spectrum of a red color luminous layer employed in an organic EL device embodying the present invention.

An embodiment of the present invention will be explained, with reference to the accompanying drawings hereinafter.

A material constituting a red color luminous layer 3 is a homopolymer of general formula (1) hereinabove. A typical homopolymer is poly(3-dodecyloxycarbonyl-2,5-thienylenebutadiynylene) given by the chemical formula (2). The spectrum of the homopolymer of chemical formula (2) is shown in FIG.1; the spectrum has a peak at 596 nm in the luminous wavelength band.

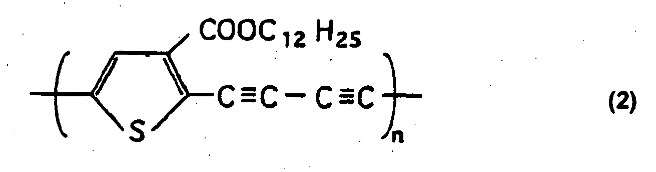

The homopolymer given by the formula (2) can be synthesised as follows.

First, under a light-shielded argon atmosphere. 5.12 g (40 mmol) of 3-thenoic acid, also called thiophenecarboxylic acid, are added to 50ml of dimethylformamide (DMF) and then 14.6 g (82 mmol) of N-bromosuccinimide is added.

The reaction solution obtained is stirred overnight to enable the reaction of equation (3) to proceed. The reaction solution is then injected into a mixture of 100ml of saturated sodium sulfate solution and 600ml water of 600 ml, and the resulting deposit is recovered. 9.38g of white needle- like crystals are obtained as a yield of 82.0% by recrystallising the deposit from an ethanol/water mixed solution. The white needle-like crystals are crystals of 2,5-dibromo-3-thenoic acid shown on the right side of the reaction equation (3).

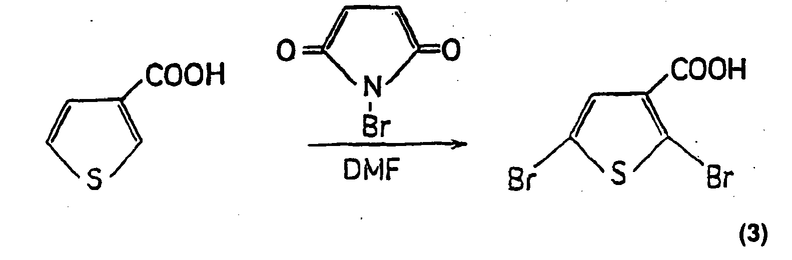

Then, 4.13 g (20 mmol) of dicyclohexylcarbodiimide (DCC) and 2.44 g (20 mmol) of dimethylaminopyridine (DMAP) are well vacuum-dried, and dichloromethane (CH₂Cl₂) is added to the resultant mixture under the argon atmosphere. When 5.72 g (20 mmol) of 2,5-dibromo-3-thenoic acid and 3.73 g (20 mmol) of dodecanol (C₁₂H₂₅0H) are added to the mixture and then stirred for three days, the reaction shown in the reaction equation (4) takes place.

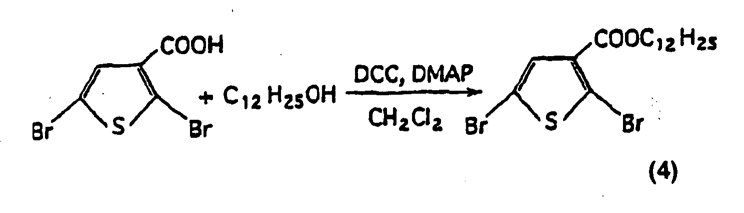

Then, 8.56 g (18.8 mmol) of white crystals are obtained as a yield 94.2% by filtering the reaction salt, and then purifying the dichloromethane by using a silica gel column employed as a developing solvent. The white crystals are the crystals of 2,5-dibromo-3-dodecyloxycarbonylthiophene, i.e., dodecyl 2,5-dibromo-3-thenoate or 3-dodecylester-2,5-dibromthiophene, shown on the right side of the chemical equation (16).

Then, 6.81 g (15 mmol) of the 3-dodecylester-2,5-dibromothiophene, 103 mg (0.54 mmol) of copper iodide (CuI) and 210 mg (0.8 mmol) of triphenylphosphine (PPh₃) are added to a mixed solution of 27 ml triethylamine (Et₃N) and 18 ml pyridine under the argon atmosphere. Then, this solution is stirred for twenty minutes while bubbling argon therethrough. Then, 3.44 g (35 mmol) of trimethylsilylacetylene ((CH₃)₃SiC≡C-H) and 105 mg (0.15 mmol) of bis(triphenylphosphine)palladium dichloride (Pd(PPh₃)₂Cl₂) are added to the resultant solution.
Then, this solution is stirred overnight while holding at 85°C, and then extraction is executed by using dichloromethane and then water. 5.93 g (11.8 mmol) of a yellow oil are obtained as a yield of 78.9 % by purifying the resultant oily layer in a silica gel column using a developing solvent that contains dichloromethane and hexane in ratio of 1:3 respectively.

The yellow oil is 3-dodecyloxycarbonyl-2,5-bis(trimethylsilylethynyl)thiophene, i.e., dodecyl-2,5-bis(trimethlsilylethynyl)-3-thenoate, that is obtained by the reaction given by the reaction equation (5).

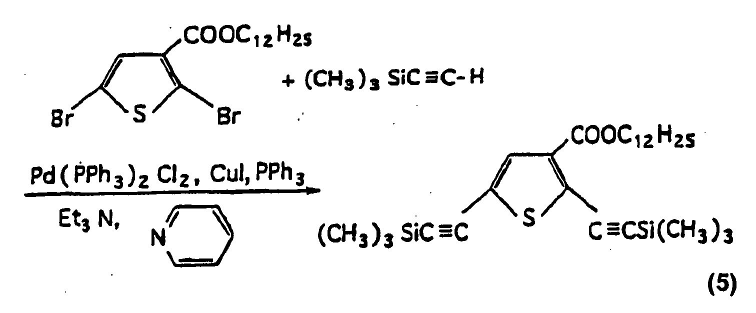

Then, 0.500 g (1 mmol) of the yellow oil is dissolved in 20mg of THF and then 0.5 ml (0.5 mmol) of tetrabutylammonium fluoride (Bu₄NF) in more THF is added. This solution is then stirred for five minutes, and then the purified product is obtained from the THF by passage through a silica gel column used as the developing solvent. Then, a catalyst solution is formed by adding 10 mg (0.1 mmol) of copper (I) chloride, 12 mg (0 1 mmol) of N,N,N',N'-tetramethylethylenediamine (TMEDA), 8mg THF and 2ml pyridine to another vessel, and then supplying oxygen to the liquid in this vessel. 10 ml of THF containing the above purified product are added in the catalyst solution, and then the reaction given by the reaction equation (6) is generated by stirring this solution for two days under an oxygen atmosphere.

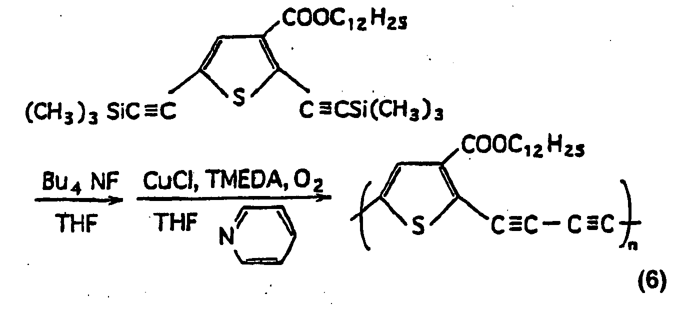

The solution in which reaction has taken place is dropped into 500ml of 2-normal (N) methanol/hydrochloric acid, and then the resultant precipitate is recovered. 203 g (0.59 mmol) of a red powder is obtained as a yield of 59.5% by dissolving this precipitate in chloroform, then dropping this liquid into 500ml methanol, and then recovering the resultant precipitate. This red powder is the product substance in chemical equation (6), i.e., the homopolymer given by the chemical formula (2).

The general formula of the homopolymer that can emit the light in the red color wavelength band and its near emission wavelength band, according to the present embodiment, is given by the formula (7). In the equation (7), the aromatic ring constituting Ar can be any one of thiophene, anthracene, pyridine, phenol, aniline, and derivatives thereof. R1 and R₂ denote substituents which can be the same or different and can be hydrogen, alkyl, alkoxyl, carboxyl, cyano, phenyl, biphenyl, or cyclohexylphenyl group respectively. n denotes the degree of polymerisation.

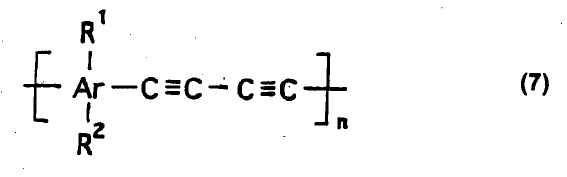

As described above, according to the present invention, a luminous layer made of the polymer of formula (7) is formed between the lower electrode and the upper electrode. In contrast to the polymers employed as the luminous layer the prior art, such polymer is hard to crystallize at ambient temperature and has a high solubility in solvents.

Accordingly, if this polymer is employed as the luminous layer, planarization of the luminous layer can be facilitated, short-circuiting between the upper electrode and the lower electrode hardly occurs, and the yield of the device can be improved.

## Claims

1. An organic luminous material having the general formula 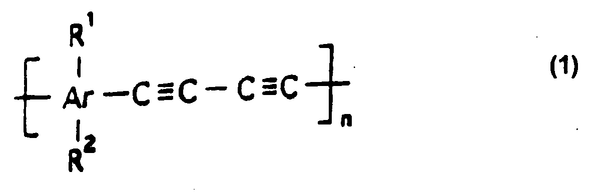 where Ar denotes an arylene group, R¹ and R² denote substituents which can be the same or different and n denotes the degree of polymerisation;
wherein an aromatic ring comprised by the arylene group is any one of thiophene, anthracene, pyridine, phenol, aniline and derivatives thereof, and the said substituents are selected from hydrogen, alkyl, alkoxy, carboxyl, cyano, phenyl, biphenyl and cyclohexylphenyl.

2. An organic light-emitting device comprising:
a lower electrode;
a luminous layer formed on the lower electrode, which is the organic luminous material as claimed in claim 1; and
an upper electrode formed on the luminous layer.

## Patentansprüche

1. Ein organisches leuchtendes Material mit der allgemeinen Formel 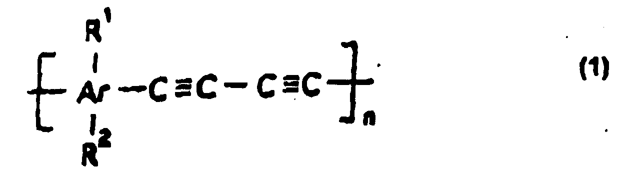 wobei Ar eine Arylengruppe bezeichnet, R¹ und R² Substituenten bezeichnen, die gleich oder verschieden sein können, und n den Grad der Polymerisation bezeichnet;
worin ein aromatischer Ring der durch die Arylengruppe gebildet, eines von Thiophen, Antracen, Pyridin, Phenol, Anilin und Derivate davon, und die Substituenten ausgewählt sind unter Wasserstoff, Alkyl, Alkkoxy, Carboxyl, Cyano, Phenyl Biphenyl und Cyclohexylphenyl.

2. Eine organische Lichtemittierende Vorrichtung mit:
einer unteren Elektrode;
einer auf der unteren Elektrode gebildeten leuchtenden Schicht, die ein organisches leuchtendes Material nach Anspruch 1 ist, und
einer oberen Elektrode, die auf der leuchtenden Schicht gebildet ist.

## Revendications

1. Matière lumineuse organique ayant la formule générale 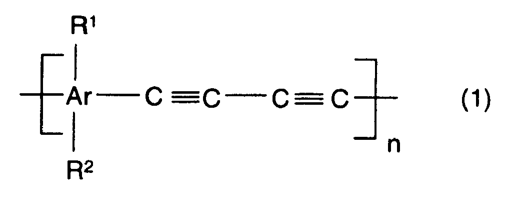 où Ar désigne un groupe arylène, R¹ et R² désignent des substituants qui peuvent être identiques ou différents et n désigne le degré de polymérisation ;
où un cycle aromatique compris par le groupe arylène est l'un quelconque parmi thiophène, anthracène, pyridine, phénol, aniline et leurs dérivés, et lesdits substituants sont choisis parmi l'hydrogène, alkyle, alcoxy, carboxyle, cyano, phényle, biphényle et cyclohexylphényle.

2. Dispositif émettant de la lumière organique comprenant :
une électrode inférieure ;
une couche lumineuse formée sur l'électrode inférieure, qui est la matière lumineuse organique selon la revendication 1 ; et
une électrode supérieure formée sur la couche lumineuse.
